# EUROPÄISCHE PATENTANMELDUNG

(11) **EP 0 901 171 A1**
(43) Veröffentlichungstag der Anmeldung: **10.03.1999**
(21) Anmeldenummer: 98115678.9
(22) Anmeldetag: 20.08.1998
(51) Int. Cl.: H01L 41/083

(54) **Elektrostriktiver Stellantrieb**

(30) Priorität: 03.09.1997 DE 19738407
(71) Anmelder: DAIMLER-BENZ AKTIENGESELLSCHAFT, 70567 Stuttgart (DE)
(72) Erfinder: Jänker, Peter, Dr., 85748 Garching (DE)

(57) **Zusammenfassung**

Bei einem elektrostriktiven Stellantrieb mit einem endseitig kraftübertragend eingespannten, bei Anlegen einer elektrischen Spannung längenveränderlichen Festkörperaktuator (4) und einer zum Schutz vor Querspannungsspitzen am Aktuator jeweils zwischen Aktuatorende und Einspannstelle angeordneten Zwischenlage (12) wird erfindungsgemäß auf baulich einfache Weise eine hubverlustarme und zugleich in Richtung der Querkontraktion des Aktuators weiche Einspannung der endseitigen Aktuaktorflächen (14, 16) dadurch erreicht, daß die Zwischenlage aus einem hinsichtlich des Elastizitätsmoduls anisotropen Material mit einer im Vergleich zum Festkörpermaterial in Aktuatorlängsrichtung deutlich höheren und in Aktuatorquerrichtung geringeren Steifigkeit besteht.

## Beschreibung

Die Erfindung bezieht sich auf einen elektrostriktiven Stellantrieb, nach dem Oberbegriff des Patentanspruchs 1.

Stellantriebe dieser Art, bei denen der Aktuator aus einem piezoelektrischen Festkörperstapel besteht, der sich beim Anlegen einer elektrischen Spannung in Längsrichtung ausdehnt und in Querrichtung kontrahiert, zeichnen sich durch hohe Stellgeschwindigkeiten, eine große Kraftentwicklung und eine hohe Auflösung aus. Da derartige Festkörperaktuatoren äußerst zugspannungsempfindlich sind, werden sie gewöhnlich, vor allem in schnellschaltenden Anwendungsfällen, durch eine Vorlastfeder in Längsrichtung vorgespannt und an ihren stellkraftbelasteten Stirnflächen durch eine Zwischenlage aus weichelastischem Material gegen übermäßige, aus der Querkontraktion im Bereich der Einspannstellen resultierende Querzugspannungen geschützt. Eine solche Zwischenlage verringert jedoch die mechanische Steifigkeit der Kraftübertragungskette, so daß die piezoelektrische Dehnbewegung, welche durch hohe Kraft und geringen Weg charakterisiert ist, nur in begrenztem Umfang genutzt werden kann.

Aufgabe der Erfindung ist es, den elektrostriktiven Stellantrieb der eingangs genannten Art so auszubilden, daß der Festkörperaktuator an seinen stellkraftübertragenden Stirnflächen wirksam und weitgehend hubverlustarm gegen örtliche Querzugspannungsspitzen geschützt wird.

Diese Aufgabe wird erfindungsgemäß durch den im Patentanspruch 1 gekennzeichneten Stellantrieb gelöst.

Bei dem erfindungsgemäßen Stellantrieb wird aufgrund der besonderen Gestaltung der Zwischenlage aus einem anisotropen Material mit einem in Aktuatorlängsrichtung deutlich höheren und quer dazu niedrigeren Elastizitätsmodul als das Festkörpermaterial auf einfache Weise eine bezüglich der Dehnbewegung hochsteife, hinsichtlich der Querkontraktion hingegen weiche Anbindung des Festkörperaktuators erzielt derart, daß die hohen Dehnungskräfte von der Zwischenlage im wesentlichen ohne Hubverlust übertragen und zugleich einspannungsbedingte, kritische Querzugbelastungen an den Kontaktflächen des Aktuators wirksam unterbunden werden und dadurch das Risiko eines mechanischen Versagens des Aktuators signifikant verringert wird.

Im Hinblick auf eine herstellungsmäßig und hinsichtlich des geforderten Steifigkeitsverhaltens günstige Ausgestaltung ist die Zwischenlage gemäß Anspruch 2 vorzugsweise aus Faserverbundwerkstoff mit einem in Aktuatorlängsrichtung unidirektionalen Faserverlauf, und zwar gemäß Anspruch 3 zweckmäßigerweise aus einem Carbon-Faserverbund hergestellt, wobei das Verhältnis der Längs- zur Quersteifigkeit der Zwischenlage, wie nach Anspruch 4 bevorzugt, mindestens 10 und vorteilhafterweise sogar über 50 beträgt und die Steifigkeit und des Festkörpermaterials annähernd verhältnisgleich zwischen den Steifigkeitswerten der Zwischenlage liegt.

In weiterer vorteilhafter Ausgestaltung der Erfindung besteht der Festkörperaktuator nach Anspruch 5 aus einem geschichteten Piezostapel und die Zwischenlage ist als stirnseitig an dem Piezostapel vollflächig anliegende, massive Druckplatte ausgebildet.

Die Erfindung wird nunmehr anhand eines Ausführungsbeispiels in Verbindung mit den Zeichnungen näher erläutert. Es zeigen in stark schematisierter Darstellung:

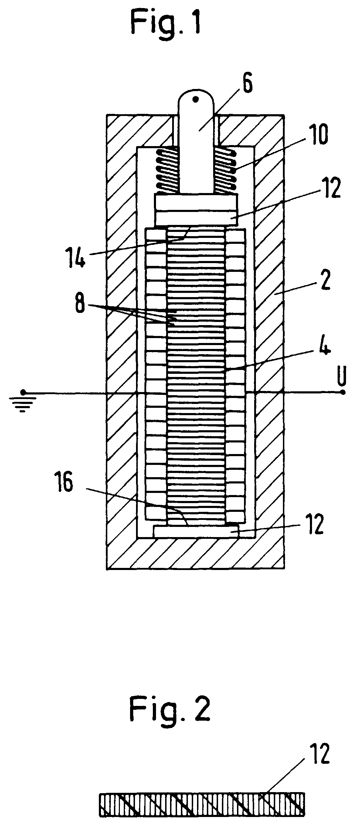

- **Fig. 1**: einen elektrostriktiven Stellantrieb nach der Erfindung im Schnitt; und
- **Fig. 2**: eine geschnittene Darstellung der Zwischenplatte des Stellantriebs nach Fig. 1.

Der in den Fig. gezeigte Stellantrieb enthält ein Gehäuse 2, in welchem ein elektrostriktiver Festkörperaktuator in Form eines geschichteten Piezostapels 4 zwischen dem Gehäuseboden und dem Ausgangsglied 6 des Stellantriebs eingespannt ist. Die einzelnen Piezoschichten 8 sind wechselweise an Masse bzw. ein Spannungpotential U angeschlossen, so daß sich der Piezostapel 4 beim Anlegen einer Betriebsspannung in Längsrichtung allsdehnt und in Querrichtung kontrahiert. Um zu verhindern, daß über das Ausgangsglied 6 äußere Zugkräfte auf den Piezostapel 4 einwirken, ist dieser durch eine Vorlastfeder 10 in Druckrichtung vorgespannt.

Zwischen dem Piezostapel 4 und dem Ausgangsglied 6 bzw. dem Gehäuseboden ist jeweils eine Zwischenplatte 12 angeordnet, an die die stirnseitige, stellkraftbelastete Aktuator-Kontaktfläche 14 bzw. 16 vollflächig angebunden ist. Die Zwischenplatten 12 sind aus Faserverbundwerkstoff mit einer in Aktuatorlängsrichtung unidirektionalen Faserorientierung hergestellt, derart, daß die mechanische Steifigkeit der Zwischenplatten 12 in Faserrichtung signifikant höher und quer dazu deutlich niedriger als die Steifigkeit des piezoelektrischen Materials des Festkörperaktuators 4 ist. So lassen sich mit einem Carbon-Faserverbundwerkstoff Elastizitätsmoduln in Faserlängsrichtung von mehr als 300 GPa und quer zur Faserrichtung von weniger als 10 GPa erzielen, während der Elastizitätsmodul des keramischen Piezomaterials etwa 50 GPa beträgt. Infolge der hohen Längssteifigkeit der Zwischenplatten 12 werden die piezoelektrischen Dehnungskräfte des Aktuators 4 im wesentlichen ohne Hubverlust an das Ausgangsglied 6 übertragen, und gleichzeitig wird durch die geringe Steifigkeit der Zwischenplatten 12 in Querrichtung eine bezüglich der Querkontraktion des Piezostapels 4 weiche Ankoppelung der Kontaktflächen 14, 16 sichergestellt, so daß diese vor kritischen Querzugspannungsspitzen wirksam geschützt werden.

## Patentansprüche

1. Elektrostriktiver Stellantrieb, mit einem endseitig kraftübertragend eingespannten, bei Anlegen einer elektrischen Spannung längenveränderlichen Festkörperaktuator und einer zum Schutz vor Querspannungsspitzen am Aktuator jeweils zwischen Aktuatorende und Einspannstelle angeordneten Zwischenlage,
**dadurch gekennzeichnet, daß**
die Zwischenlage (12) aus einem bezüglich des Elastizitätsmoduls anisotropen Material mit einer im Vergleich zum Festkörpermaterial in Aktuatorlängsrichtung hohen und in Aktuatorquerrichtung geringen Steifigkeit hergestellt ist.

2. Stellantrieb nach Anspruch 1,
**dadurch gekennzeichnet, daß**
die Zwischenlage (12) aus Faserverbundwerkstoff mit einem in Aktuatorlängsrichtung unidirektionalen Faserverlauf besteht.

3. Stellantrieb nach Anspruch 2,
**dadurch gekennzeichnet, daß**
die Zwischenlage (12) aus einem Carbon-Faserverbund besteht.

4. Stellantrieb nach einem der vorhergehenden Ansprüche,
**dadurch gekennzeichnet, daß**
das Verhältnis des Elastizitätsmoduls der Zwischenlage (12) in Aktuatorlängsrichtung zu dem in Aktuatorquerrichtung größer als 10 ist.

5. Stellantrieb nach einem der vorhergehenden Ansprüche,
**dadurch gekennzeichnet, daß**
der Festkörperaktuator (4) aus einem Piezostapel besteht und die Zwischenlage (12) als stirnseitig mit dem Piezostapel vollflächig verkoppelte, massive Druckplatte ausgebildet ist.
